# EUROPEAN PATENT APPLICATION

(11) **EP 4 834 649 A1**
(43) Date of publication of application: **04.11.2026**
(21) Application number: 24909774.2
(22) Date of filing: 06.08.2024
(51) Int. Cl.: B60L 58/10, B60L 58/16, H01M 10/42, G01R 31/396

(54) **EARLY WARNING METHOD FOR STARTER BATTERY, STORAGE MEDIUM AND ELECTRONIC DEVICE**

(30) Priority: 28.12.2023 CN 202311851262
(71) Applicant: BYD Company Limited, Shenzhen, Guangdong 518118 (CN)
(72) Inventor: LI, Hengfeng, Shenzhen, Guangdong 518118 (CN); SHU, Shiwei, Shenzhen, Guangdong 518118 (CN); FENG, Tianyu, Shenzhen, Guangdong 518118 (CN)
(74) Representative: Mathys & Squire
(86) International application number: PCT/CN2024/109975
(87) International publication number: WO 2025/138820

(57) **Abstract**

An early warning method for a starter battery, a storage medium and an electronic device, relating to the technical field of battery detection. The early warning method includes: acquiring state information data of a starter battery uploaded by a vehicle battery management system, wherein the state information data includes at least one of voltage data, current data, temperature data and charging data **(S11);** on the basis of the state information data, detecting whether the starter battery has an anomaly (S12); and, if the starter battery has an anomaly, sending anomaly early warning information to a manufacturer service platform for the starter battery and/or a user terminal bound to the vehicle (S13).

## Description

### CROSS-REFERENCE TO RELATED APPLICATIONS

The present disclosure claims priority to the Chinese patent Disclosure No. "202311851262.4" filed on December 28, 2023, entitled "EARLY WARNING METHOD FOR STARTER BATTERY, STORAGE MEDIUM AND ELECTRONIC DEVICE", the contents of which are incorporated herein by reference in its entirety.

### FIELD

The present disclosure relates to the technical field of battery detection, and in particular to an early warning method for a starter battery, a storage medium and an electronic device.

### BACKGROUND

The starter battery for starting a vehicle not only supplies power for starting the engine of the vehicle, but also provides required electrical energy for other power components in the vehicle. Once the starter battery is damaged or aged, the normal operation of devices such as lights, braking systems, and audio equipment can be affected. Therefore, there is an urgent need for a method capable of early detection of starter battery aging, damage, or other faults, so as to take timely measures to deal with them and ensure normal operation of the vehicle.

### SUMMARY

The present disclosure aims to provide an early warning method for a starter battery, a storage medium and an electronic device to realize timely detection and warning of starter battery anomaly and facilitate timely maintenance of the starter battery.

To achieve the above objective, the first aspect of the present disclosure provides an early warning method for a starter battery includes: obtaining state information data of the starter battery uploaded by a vehicle battery management system, wherein the state information data includes at least one of voltage data, current data, temperature data, and charging data; detecting whether the starter battery is abnormal according to the state information data; and if the starter battery is abnormal, sending abnormal warning information to a manufacturer service platform of the starter battery and/or a user terminal bound to the vehicle.

According to one embodiment of the present disclosure, before the step of detecting whether the starter battery is abnormal according to the state information data, the method further includes: preprocessing the state information data, wherein the preprocessing comprises at least one of time sorting, removing null values, removing duplicate data, and removing invalid values.

According to one embodiment of the present disclosure, wherein the step of detecting whether the starter battery is abnormal according to the state information data includes: determining a minimum voltage value in the voltage data in a current low voltage detection period; and if the minimum voltage is less than a low voltage warning threshold, determining that the starter battery is abnormal.

According to one embodiment of the present disclosure, wherein the step of detecting whether the starter battery is abnormal according to the state information data includes: selecting valid voltage values of the voltage data in a current voltage difference detection period; counting a voltage frame number of the valid voltage values and calculating a voltage difference average of the valid voltage values; and if the voltage frame number is greater than a voltage difference warning frame number and the voltage difference average is greater than a voltage difference warning threshold, determining that the starter battery is abnormal.

According to one of the embodiments of the present disclosure, wherein a plurality of current values of the current data correspond to a plurality of voltage values of the voltage data one by one, and the step of selecting the valid voltage values of the voltage data in the current voltage difference detection period includes: determining a target current value in the current data that is less than a pre-set current threshold; and taking a voltage value corresponding to the target current as the valid voltage value.

According to one of the embodiments of the present disclosure, wherein the step of calculating the voltage difference average of the valid voltage values includes: determining a minimum value and a maximum value in the valid voltage values; calculating a voltage difference between the maximum value and the minimum value; and taking a ratio of the voltage difference to the voltage frame number as the voltage difference average.

According to one of the embodiments of the present disclosure, the method further includes: obtaining in-vehicle temperature data and out-of-vehicle temperature data of the vehicle uploaded by the battery management system; wherein the step of detecting whether the starter battery is abnormal according to the state information data includes: selecting a valid temperature value of the temperature data in a current temperature detection period; counting a temperature frame number of the valid temperature values, and obtaining a maximum average temperature difference according to the valid temperature values, the in-vehicle temperature data and the out-of-vehicle temperature data; and determining that the starter battery is abnormal if the temperature frame number is greater than a temperature warning frame number and the maximum average temperature difference is greater than a temperature warning threshold.

According to one of the embodiments of the present disclosure, wherein the step of selecting the valid temperature values in the temperature data in the current temperature detection period includes: selecting the temperature values greater than a starter battery safety temperature value in the current temperature detection period as the valid temperature values.

According to one of the embodiments of the present disclosure, wherein a plurality of temperature values of the temperature data correspond to a plurality of in-vehicle temperature values of the in-vehicle temperature data and a plurality of out-of-vehicle temperature values of the out-of-vehicle temperature data in a one-to-one configuration, and obtaining the maximum average temperature difference according to the valid temperature values, the in-vehicle temperature data and the out-of-vehicle temperature data includes: calculating a first temperature difference between each of the valid temperature values and a corresponding in-vehicle temperature value respectively, and calculating a second temperature difference between each of the valid temperature values and a corresponding out-of-vehicle temperature value respectively; calculating a first average of the first temperature differences and a second average of the second temperature differences; and taking a larger one of the first average and the second average as the maximum average temperature difference.

According to one of the embodiments of the present disclosure, wherein the step of detecting whether the starter battery is abnormal according to the state information data includes: obtaining an effective charging number in a current charging detection period according to the charging data; and determining that the starter battery is abnormal if the effective charging number is greater than a charging number warning threshold.

According to one of the embodiments of the present disclosure, wherein the charging data comprises a charging time and a starter battery voltage at the end of each charging process, and an effective charging process is a charging process with a charging time greater than a pre-set charging time threshold and a starter battery voltage at the end of the charging process reaching a pre-set charging voltage threshold.

To achieve the above objective, the second aspect of the present disclosure provides a computer readable storage medium which has a computer program stored thereon, when the computer program is executed by a processor, the early warning method of the starter battery according to the first aspect of the present disclosure is implemented.

To achieve the above objective, the third aspect of the present disclosure provides an electronic device, includes a memory, a processor, and a computer program stored on the memory, when the computer program is executed by the processor, the early warning method of the starter battery according to the first aspect of the present disclosure is implemented.

In the early warning method of the starter battery, the storage medium, and the electronic device of the present disclosure, firstly the state information data of the starter battery is acquired, then whether the starter battery is abnormal according to the state information data is detected, if the starter battery is abnormal, and the abnormal warning information shall be sent to the manufacturer service platform of the starter battery and/or the user terminal bound to the vehicle. Therefore, the starter battery anomaly can be detected and warned in time, and the starter battery can be maintained in time.

Additional aspects and advantages of the present disclosure will be set forth in the following description, part will become apparent from the following description, or will be learned through practice of the present disclosure.

### BRIEF DESCRIPTION OF THE DRAWINGS

FIG. 1 is a flow chart of an early warning method of the starter battery according to an embodiment of the present disclosure;
FIG. 2 is a flow chart of an early warning method of the starter battery according to a specific embodiment of the present disclosure;
FIG. 3 is a system schematic implementing the early warning method of the starter battery according to an embodiment of the present disclosure;
FIG. 4 is a structural schematic of an electronic device according to an embodiment of the present disclosure.

### DETAILED DESCRIPTION

The embodiments of the present disclosure are described in detail below, examples are shown in the drawings, wherein the same or similar reference numerals represent the same or similar elements or elements having the same or similar functions throughout. The embodiments described below by referring to the drawings are exemplary and are intended to explain the present disclosure, will not be understood as a limitation of the present disclosure.

The early warning method of the starter battery, the storage medium, and the electronic device of the present disclosure are described below with reference to the drawings.

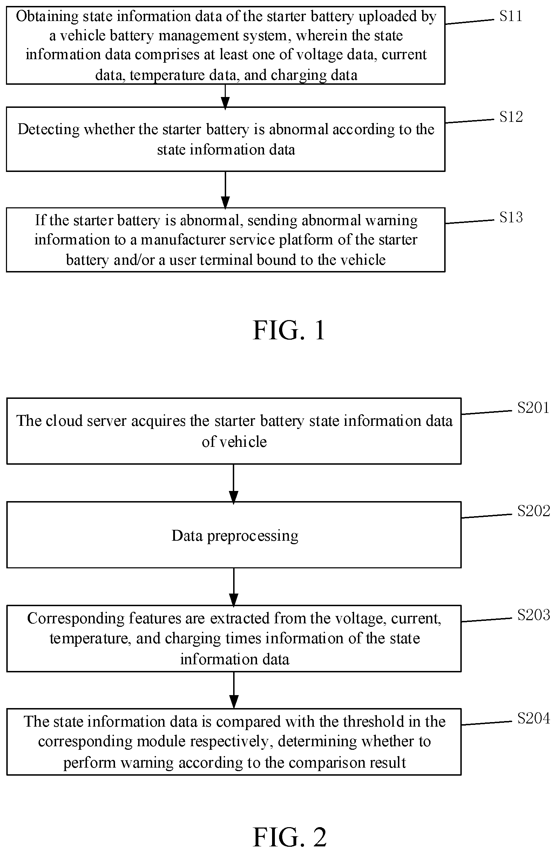

FIG. 1 is a flow chart of the early warning method of the starter battery according to an embodiment of the present disclosure;
As shown in FIG. 1, the early warning method of the starter battery comprises:
S11, obtaining state information data of the starter battery uploaded by a vehicle battery management system, wherein the state information data comprises at least one of voltage data, current data, temperature data, and charging data.

Specifically, the voltage data, the current data, the temperature data, and the charging data of the starter battery etc. can be obtained by a BMS (Battery Management System) of the vehicle. After obtaining the data, the BMS can upload the above state information data to a specific electronic device, such as a cloud server etc., in the form of data frames at a pre-set time interval, the specific electronic device executes the early warning method of the starter battery in the embodiments of the present disclosure. Hereinafter, the cloud server is taken as an example for description.

S12, detecting whether the starter battery is abnormal according to the state information data.

In some embodiments of the present disclosure, when the state information data comprises the voltage data, wherein the step of detecting whether the starter battery is abnormal according to the state information data comprises: determining a minimum voltage value in the voltage data in a current low voltage detection period; and if the minimum voltage is less than a low voltage warning threshold, determining that the starter battery is abnormal.

Specifically, the cloud server can perform low voltage anomaly detection once every other low voltage detection period; and the low voltage anomaly detection can be performed by a low voltage anomaly detection module. In the current low voltage detection period, the low voltage anomaly detection module compares the minimum voltage value of the voltage data in the current low voltage detection period with the low voltage warning threshold, determining that the starter battery is in a low voltage anomaly if the minimum voltage value is less than the low voltage warning threshold. Especially, the low voltage detection period is greater than the pre-set time interval.

In some embodiments of the present disclosure, when the state information data comprises the voltage data, wherein the step of detecting whether the starter battery is abnormal according to the state information data comprises: selecting valid voltage values of the voltage data in a current voltage difference detection period; counting a voltage frame number of the valid voltage values and calculating a voltage difference average of the valid voltage values; and if the voltage frame number is greater than a voltage difference warning frame number and the voltage difference average is greater than a voltage difference warning threshold, determining that the starter battery is abnormal.

Specifically, the cloud server can perform voltage difference anomaly detection once every other voltage difference detection period, and the voltage difference anomaly detection can be performed by a voltage difference anomaly detection module. In the current voltage difference detection period, the voltage difference anomaly detection module selects the valid voltage values of the voltage data in the current voltage difference detection period; counts the number of voltage frames (i.e., the number of corresponding data frames) of the valid voltage values, and calculates the voltage difference average value of the valid voltage values; and determines that the starter battery is in a voltage difference anomaly if the number of voltage frames is greater than a voltage difference warning frame number, while the voltage difference average value is greater than a voltage difference warning threshold. Especially, the voltage difference detection period is greater than the pre-set time interval and can be equal to the low voltage anomaly detection period.

Optionally, the voltage difference anomaly detection module can also directly subtract the maximum value from the minimum value in the valid voltage values, comparing the difference with a corresponding voltage difference warning threshold (which is different from the voltage difference warning threshold compared with the voltage difference average value), determining that the starter battery is in a voltage difference anomaly when the difference is greater than the voltage difference warning threshold. Compared with the comparison of the voltage difference average value and the number of voltage frames, the voltage difference is compared only, the calculation complexity is low, but the reliability is also low.

In some embodiments of the present disclosure, the state information data further comprises current data, wherein a plurality of current values of the current data correspond to a plurality of voltage values of the voltage data one by one, and the step of selecting the valid voltage values of the voltage data in the current voltage difference detection period comprises: determining a target current value in the current data that is less than a pre-set current threshold; and taking a voltage value corresponding to the target current as the valid voltage value.

Specifically, in order to improve the accuracy of voltage difference anomaly detection, voltage data susceptible to current can be first removed, mainly voltage values corresponding to current values greater than a pre-set current threshold. For example, when the charging current of the starter battery is large, the voltage of the starter battery is unstable. Based on this, the valid voltage value can be a voltage value corresponding to a target current value less than the pre-set current threshold in the current data. Using the valid voltage value for voltage difference anomaly detection can improve the accuracy and reliability of detection.

In some embodiments of the present disclosure, wherein the step of calculating the voltage difference average of the valid voltage values comprises: determining a minimum value and a maximum value in the valid voltage values; calculating a voltage difference between the maximum value and the minimum value; and taking a ratio of the voltage difference to the voltage frame number as the voltage difference average.

Specifically, after the voltage data susceptible to current is removed, the voltage difference mean value of the valid voltage data can be calculated, and the calculation formula can be Vmean=(Vmax-Vmin)/voltage frame number. Vmean is compared with the voltage difference warning threshold, and the voltage frame number corresponding to the valid voltage value is compared with the voltage difference warning frame number. If Vmean is greater than the voltage difference warning threshold, the voltage frame number corresponding to the valid voltage value is greater than the voltage difference warning frame number, determining that the starter battery has a voltage difference anomaly.

In some embodiments of the present disclosure, when the state information data comprises temperature data, obtaining in-vehicle temperature data and out-of-vehicle temperature data of the vehicle uploaded by the battery management system; wherein the step of detecting whether the starter battery is abnormal according to the state information data comprises: selecting a valid temperature value of the temperature data in a current temperature detection period; counting a temperature frame number of the valid temperature values, and obtaining a maximum average temperature difference according to the valid temperature values, the in-vehicle temperature data and the out-of-vehicle temperature data; and determining that the starter battery is abnormal if the temperature frame number is greater than a temperature warning frame number and the maximum average temperature difference is greater than a temperature warning threshold.

Specifically, the BMS can upload the in-vehicle temperature data and the out-of-vehicle temperature data to the cloud server in the form of data frames with the state information of the starter battery together. The cloud server can perform temperature anomaly detection once every other temperature detection period. The temperature anomaly detection can be performed by a temperature anomaly detection module. In the current temperature detection period, the temperature anomaly detection module selects valid temperature values of the temperature data in the current temperature detection period; counts the temperature frame number (i.e., the corresponding data frame number) of the valid temperature values, and obtains an maximum average temperature difference according to the valid temperature values, the in-vehicle temperature data and the out-of-vehicle temperature data; if the temperature frame number is greater than a temperature warning frame number and the maximum average temperature difference is greater than a temperature warning threshold, determining that the starter battery has a temperature anomaly. Especially, the temperature detection period is greater than the pre-set time interval and can be equal to the low voltage anomaly detection period and the voltage difference anomaly detection period.

In some embodiments of the present disclosure, wherein the step of selecting the valid temperature values in the temperature data in the current temperature detection period comprises: selecting the temperature values greater than a starter battery safety temperature value in the current temperature detection period as the valid temperature values.

Specifically, in order to improve the accuracy of temperature anomaly detection, the temperature values greater than the safe temperature value of the starter battery can be used as the valid temperature values for temperature anomaly detection.

In some embodiments of the present disclosure, wherein a plurality of temperature values of the temperature data correspond to a plurality of in-vehicle temperature values of the in-vehicle temperature data and a plurality of out-of-vehicle temperature values of the out-of-vehicle temperature data in a one-to-one configuration, and obtaining the maximum average temperature difference according to the valid temperature values, the in-vehicle temperature data and the out-of-vehicle temperature data comprises: calculating a first temperature difference between each of the valid temperature values and a corresponding in-vehicle temperature value respectively, and calculating a second temperature difference between each of the valid temperature values and a corresponding out-of-vehicle temperature value respectively; calculating a first average of the first temperature differences and a second average of the second temperature differences; and taking a larger one of the first average and the second average as the maximum average temperature difference.

Specifically, after selecting the temperature values greater than the safe temperature value of the starter battery of the temperature data in the current temperature detection period as the valid temperature values, the average temperature differences between the valid temperature values and the in-vehicle temperature and the out-of-vehicle temperature are calculated respectively, and the maximum value of the two average temperature differences is used to compare the temperature difference threshold, that is, Tmean = max(mean(Tstarter battery - Tin-vehicle temperature), mean(Tstarter battery - Tout-vehicle temperature)). The temperature data in the starter battery parameters are compared with the temperature anomaly warning threshold, and the comparison information comprises the maximum average temperature difference of the starter battery temperature, the in-vehicle temperature and the out-of-vehicle temperature, and the temperature frame number corresponding to the valid temperature values. If the maximum average temperature difference is greater than the temperature warning threshold and the temperature frame number is greater than the temperature warning frame number, determining that the starter battery has a temperature anomaly.

In some embodiments of the present disclosure, when the state information data comprises charging data, wherein the step of detecting whether the starter battery is abnormal according to the state information data comprises: obtaining an effective charging number in a current charging detection period according to the charging data; and determining that the starter battery is abnormal if the effective charging number is greater than a charging number warning threshold.

In this embodiment, wherein the charging data comprises a charging time and a starter battery voltage at the end of each charging process, and an effective charging process is a charging process with a charging time greater than a pre-set charging time threshold and a starter battery voltage at the end of the charging process reaching a pre-set charging voltage threshold.

Specifically, the cloud server can perform charging anomaly detection once every other charging detection period. The charging anomaly detection can be performed by a charging anomaly detection module. In a certain time window (i.e., a certain charging detection period), the charging anomaly detection module can count the number of effective charging times of the starter battery, wherein the standard for effective charging is that the charging time and the terminal voltage of charging both reach corresponding thresholds. The number of effective charging times in the time window is compared with a charging number warning threshold. If the number of effective charging times is greater than the charging number warning threshold, determining that the starter battery has charging anomaly.

In some embodiments of the present disclosure, before detecting whether the starter battery has anomaly according to the state information data, the method further comprises: preprocessing the state information data, wherein the preprocessing comprises at least one of time sorting, removing null values, removing duplicate data, and removing invalid values.

Specifically, due to noise influence or interference in the process of data acquisition, transmission, etc., null values, duplicate data, invalid values, etc. can appear in the state information data acquired by the cloud server. To improve the accuracy and reliability of starter battery anomaly detection, the state information data can be processed to remove null values, duplicate data, invalid values, etc. before anomaly detection. Meanwhile, to facilitate determination of the detection timing of starter battery anomaly detection, the state information data can be time sorted. After the preprocessing such as time sorting, null value removal, duplicate data removal, invalid value removal, etc. is performed, the preprocessed data can be input into each anomaly detection model. The anomaly detection models comprise the low voltage anomaly detection module, the voltage difference anomaly detection module, the temperature anomaly detection module, and the charging anomaly detection module. Different detection modules are configured with different warning thresholds, and each threshold is determined according to historical starter battery parameters.

S13, if the starter battery is abnormal, sending abnormal warning information to a manufacturer service platform of the starter battery and/or a user terminal bound to the vehicle.

Specifically, when each anomaly detection module detects starter battery anomaly, the cloud server can send corresponding anomaly warning information to the manufacturer service platform of the starter battery and/or the user terminal bound to the vehicle, for example, when the starter battery has low voltage anomaly, sending warning information containing the low voltage anomaly, so that the manufacturer or the vehicle owner can timely and targetedly maintain the starter battery.

To facilitate understanding, the following describes an early warning method of the starter battery of one specific embodiment of the present disclosure in combination with FIG. 2.

As shown in FIG. 2, the early warning method of the starter battery comprises:
S201, the cloud server acquires the starter battery state information data of vehicle.

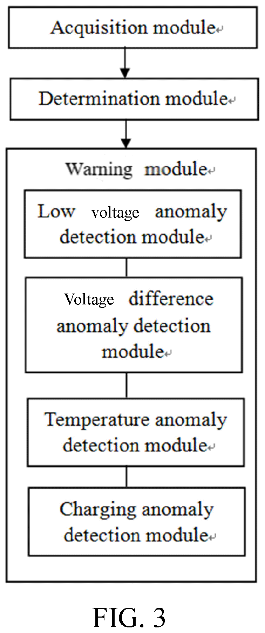

Specifically, this flow measures the state information data such as the voltage, current, temperature, and charging times of the starter battery, and uploads the data to the cloud server through the BMS system. At this time, the state information data can be acquired by the acquisition module in the cloud server shown in FIG. 3.

S202, data preprocessing.

S203, corresponding features are extracted from the voltage, current, temperature, and charging times information of the state information data.

Specifically, the uploaded state information such as the voltage, current, temperature, and charging times of the starter battery is used to monitor voltage anomaly, self-discharge anomaly, temperature anomaly, and charging anomaly of the starter battery, and to perform multi-faceted warning on the starter battery.

S204, the state information data is compared with the threshold in the corresponding module respectively, determining whether to perform warning according to the comparison result.

Specifically, after the acquisition module acquires the state information data, the determination module in the cloud server shown in FIG. 3 can preprocess and extract features from the state information data, and then send the extracted features to the corresponding anomaly detection module (including the low voltage anomaly detection module, the voltage difference anomaly detection module, the temperature anomaly detection module, and the charging anomaly detection module) in the warning module. Determining whether the corresponding warning item exceeds the warning threshold by each anomaly detection model, and warning is performed if it does. If warning is performed, the cloud server can send the warning information to the manufacturer and the customer in the first time, so as to remind the customer to replace the starter battery in time through the manufacturer, or directly remind the customer to replace the starter battery in time. Meanwhile, the manufacturer can also optimize the production of the starter battery according to the warning information issued for the starting batteries of different vehicles, so as to improve the health status of subsequent starting batteries.

The warning method for the starter battery in the embodiment of the present disclosure, the state information data of the starter battery is uploaded to the cloud server through the BMS system, each anomaly detection model in the cloud server performs anomaly warning on the starter battery by using the uploaded state information such as the voltage, current, temperature, and charging times of the starter battery, and when warning is needed, the cloud server can send the warning information to the manufacturer and the customer in the first time, so as to replace the starter battery in time and ensure the normal operation of the vehicle.

Based on the above-mentioned early warning method of the starter battery, the present disclosure further provides a computer-readable storage medium.

In this embodiment, a computer program is stored thereon, and when executed by a processor, the computer program implements the above-mentioned early warning method for the starter battery.

Based on the above-mentioned early warning method of the starter battery, the present disclosure further provides an electronic device.

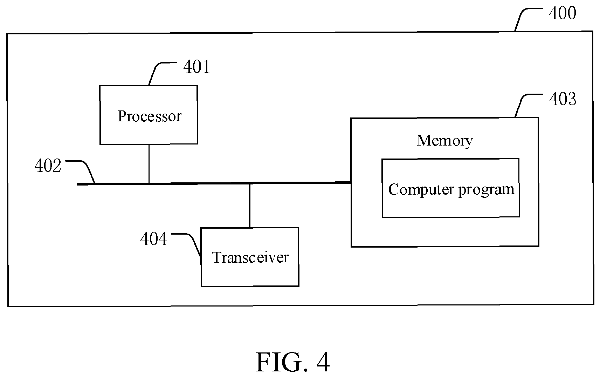

FIG. 4 is a structural schematic of an electronic device according to an embodiment of the present disclosure.

As shown in FIG. 4, the electronic device 400 comprises a processor 401, a memory 403, and a computer program stored on the memory, and when executed by the processor, the computer program implements the above-mentioned early warning method of the starter battery.

The processor 401 can be a CPU (Central Processing Unit), a general purpose processor, a DSP (Digital Signal Processor), an ASIC (Application Specific Integrated Circuit), an FPGA (Field Programmable Gate Array) or other programmable logic device, a transistor logic device, a hardware component, or any combination thereof. The processor 401 can implement or execute various example logical blocks, modules, and circuits described in connection with the present disclosure. The processor 401 can also be implemented or performed by a combination of computing logic, such as a combination of one or more microprocessors, a combination of a DSP and a microprocessor, or the like.

The bus 402 can comprise a path that permits information to be transferred from one component of the apparatus to another. The bus 402 can be a PCI (Peripheral Component Interconnect), EISA (Extended Industry Standard Architecture) or another bus. The bus 402 can be divided into an address bus, a data bus, a control bus, etc. One thick line in FIG.4 is merely used for convenience of representation, but is not intended to represent that only one bus or one type of bus exists.

The memory 403 is configured to store a computer program corresponding to the early warning method for starting a battery in the embodiments of the present disclosure. The processor 401 is configured to execute the computer program stored in the memory 403 to implement the content shown in the foregoing method embodiments.

The electronic device 400 comprises, but is not limited to, a mobile terminal such as a mobile phone, a laptop computer, a digital broadcasting receiver, a PDA (Personal Digital Assistant), a PAD (Personal Digital Assistant), a PMP (Portable Multimedia Player), a vehicle terminal, and a stationary terminal such as a cloud server, a digital TV, and a desktop computer. The electronic device 400 shown in FIG. 4 is merely an example, and will not impose any limitation on the function and use range of the embodiments of the present disclosure.

Note that, logic and/or steps represented in flow charts or otherwise described herein, for example, it can be considered a sequence listing of executable instructions for implementing logical functions, may be embodied in any computer readable medium, for use by an instruction execution system, apparatus, or device, such as a computer-based system, processor-including system, or other system that can fetch the instructions from the instruction execution system, apparatus, or device and execute the instructions, or used in connection with these instruction execution systems, apparatus, or devices. In the case of the present specification, a "computer-readable medium" can be any apparatus that can contain, store, communicate, propagate, or transport the program for use by or in connection with the instruction execution system, apparatus, or device. More specific examples (a non-exhaustive list) of the computer-readable medium include the following: an electrical connection (electronic device) including one or more wirings, a portable computer tray (magnetic device), a random access memory (RAM), a read-only memory (ROM), an erasable editable read-only memory (EPROM or Flash memory), an optical fiber device, and a portable compact disc read-only memory (CDROM) .The computer readable medium could even be paper or other suitable medium onto which the program can be printed, as the program can be electronically obtained, for example, by optically scanning the paper or other medium, followed by editing, interpreting, or otherwise processing in a suitable manner as necessary, and then stored in a computer memory.

It will be understood that portions of the present disclosure can be implemented in hardware, software, firmware, or a combination thereof. In the above embodiments, the plurality of steps or methods can be implemented in software or firmware stored in a memory and executed by a suitable instruction execution system. For example, if implemented in hardware, as in another embodiment, this can be accomplished with any or a combination of the following technologies, which are all well known in the art: a discrete logic circuit having logic gates for implementing logic functions upon data signals, an application specific integrated circuit having appropriate combinational logic gates, a programmable gate array (PGA), a field programmable gate array (FPGA), etc.

In the description of the specification, reference to terms such as "an embodiment", "some embodiments", "an example", "a specific example" or "some examples" etc., mean that the particular feature(s), structure(s), material(s) or characteristic(s) described in connection with the embodiment or example is comprised in at least one embodiment or example of the disclosure. The appearances of such terms in various places of the specification are not necessarily all referring to the same embodiment or example. Moreover, described features, structures, materials, or characteristics can be combined in any suitable manner in one or more embodiments or examples.

In the description of the present disclosure, it will be understood that the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential" and the like indicate the orientation or positional relationship based on the orientation or positional relationship shown in the drawings, and are only for the convenience of describing the present disclosure and simplifying the description, and do not indicate or imply that the device or element referred to must have a particular orientation, be constructed and operated in a particular orientation, and therefore will not be understood as a limitation on the present disclosure.

In addition, the terms "first", "second", and the like are used herein for descriptive purposes only and are not intended to indicate or imply relative importance or a number of indicated technical features. Thus, features defined with "first", "second" can comprise at least one of the features explicitly or implicitly. In the description of the present disclosure, the meaning of "a plurality of" is at least two, for example, two, three, and the like, unless otherwise explicitly and specifically defined.

In the present disclosure, unless otherwise clearly specified and limited, the terms "mounting", "connecting", "fixing" and the like will be understood in a broad sense, for example, can be fixed connection, can also be detachable connection, or integral; can be mechanical connection, can also be electrical connection; can be directly connected, can also be indirectly connected through an intermediate medium, can be the internal communication of two elements or the interaction relationship of two elements, unless otherwise clearly defined. For those of ordinary skill in the art, the specific meanings of the above terms in the present disclosure will be understood according to the specific circumstances.

In the present disclosure, unless otherwise clearly specified and limited, the first feature "on" or "under" the second feature can be that the first and second features are in direct contact, or the first and second features are in indirect contact through an intermediate medium. Moreover, the first feature "on", "above" and "over" the second feature can be that the first feature is directly above or obliquely above the second feature, or only indicates that the horizontal height of the first feature is higher than that of the second feature. The first feature "under", "below" and "under" the second feature can be that the first feature is directly below or obliquely below the second feature, or only indicates that the horizontal height of the first feature is less than that of the second feature.

Although the above has shown and described the embodiments of the present disclosure, it will be understood that the above embodiments are exemplary and will not be understood as a limitation on the present disclosure, and those of ordinary skill in the art can make changes, modifications, replacements and variations to the above embodiments within the scope of the present disclosure.

## Claims

1. An early warning method for a starter battery, comprising:
obtaining state information data of the starter battery uploaded by a vehicle battery management system, wherein the state information data comprises at least one of voltage data, current data, temperature data, and charging data;
detecting whether the starter battery is abnormal according to the state information data; and
if the starter battery is abnormal, sending abnormal warning information to a manufacturer service platform of the starter battery and/or a user terminal bound to the vehicle.

2. The early warning method for a starter battery according to claim 1, before the step of detecting whether the starter battery is abnormal according to the state information data, the method further comprises:
preprocessing the state information data, wherein the preprocessing comprises at least one of time sorting, removing null values, removing duplicate data, and removing invalid values.

3. The early warning method for a starter battery according to claim 1 or 2, wherein the step of detecting whether the starter battery is abnormal according to the state information data comprises:
determining a minimum voltage value in the voltage data in a current low voltage detection period; and
if the minimum voltage is less than a low voltage warning threshold, determining that the starter battery is abnormal.

4. The early warning method for a starter battery according to claim 1 or 2, wherein the step of detecting whether the starter battery is abnormal according to the state information data comprises:
selecting valid voltage values of the voltage data in a current voltage difference detection period;
counting a voltage frame number of the valid voltage values and calculating a voltage difference average of the valid voltage values; and
if the voltage frame number is greater than a voltage difference warning frame number and the voltage difference average is greater than a voltage difference warning threshold, determining that the starter battery is abnormal.

5. The early warning method for a starter battery according to claim 4, wherein a plurality of current values of the current data correspond to a plurality of voltage values of the voltage data one by one, and the step of selecting the valid voltage values of the voltage data in the current voltage difference detection period comprises:
determining a target current value in the current data that is less than a pre-set current threshold; and
taking a voltage value corresponding to the target current as the valid voltage value.

6. The early warning method for a starter battery according to claim 4 or 5, wherein the step of calculating the voltage difference average of the valid voltage values comprises:
determining a minimum value and a maximum value in the valid voltage values;
calculating a voltage difference between the maximum value and the minimum value; and
taking a ratio of the voltage difference to the voltage frame number as the voltage difference average.

7. The early warning method for a starter battery according to any one of claims 1 to 6 further comprises:
obtaining in-vehicle temperature data and out-of-vehicle temperature data of the vehicle uploaded by the battery management system;
wherein the step of detecting whether the starter battery is abnormal according to the state information data comprises:
selecting a valid temperature value of the temperature data in a current temperature detection period;
counting a temperature frame number of the valid temperature values, and obtaining a maximum average temperature difference according to the valid temperature values, the in-vehicle temperature data and the out-of-vehicle temperature data; and
determining that the starter battery is abnormal if the temperature frame number is greater than a temperature warning frame number and the maximum average temperature difference is greater than a temperature warning threshold.

8. The early warning method of the starter battery according to claim 7, wherein the step of selecting the valid temperature values in the temperature data in the current temperature detection period comprises:
selecting the temperature values greater than a starter battery safety temperature value in the current temperature detection period as the valid temperature values.

9. The early warning method of the starter battery according to claim 7 or 8, wherein a plurality of temperature values of the temperature data correspond to a plurality of in-vehicle temperature values of the in-vehicle temperature data and a plurality of out-of-vehicle temperature values of the out-of-vehicle temperature data in a one-to-one configuration, and obtaining the maximum average temperature difference according to the valid temperature values, the in-vehicle temperature data and the out-of-vehicle temperature data comprises:
calculating a first temperature difference between each of the valid temperature values and a corresponding in-vehicle temperature value respectively, and calculating a second temperature difference between each of the valid temperature values and a corresponding out-of-vehicle temperature value respectively;
calculating a first average of the first temperature differences and a second average of the second temperature differences; and
taking a larger one of the first average and the second average as the maximum average temperature difference.

10. The early warning method of the starter battery according to any one of claims 1 to 9, wherein the step of detecting whether the starter battery is abnormal according to the state information data comprises:
obtaining an effective charging number in a current charging detection period according to the charging data; and
determining that the starter battery is abnormal if the effective charging number is greater than a charging number warning threshold.

11. The early warning method of the starter battery according to claim 10, wherein the charging data comprises a charging time and a starter battery voltage at the end of each charging process, and an effective charging process is a charging process with a charging time greater than a pre-set charging time threshold and a starter battery voltage at the end of the charging process reaching a pre-set charging voltage threshold.

12. A computer readable storage medium, having stored thereon a computer program, wherein the computer program, when the computer program is executed by a processor, implements the early warning method of the starter battery according to any one of claims 1 to 11.

13. An electronic device, comprising a memory, a processor, and a computer program stored on the memory, wherein the computer program, when the computer program is executed by the processor, implements the early warning method of the starter battery according to any one of claims 1 to 11.
